# EUROPÄISCHE PATENTANMELDUNG

(11) **EP 4 776 761 A1**
(43) Veröffentlichungstag der Anmeldung: **15.07.2026**
(21) Anmeldenummer: 25151395.8
(22) Anmeldetag: 13.01.2025
(51) Int. Cl.: H05K 1/14, H05K 3/30, H05K 3/36, H01R 12/52, H01R 12/57, H01R 12/58, H05K 1/02

(54) **HALBLEITERLEISTUNGSRELAIS UND VERFAHREN**

(71) Anmelder: Kliem, Thomas, 78628 Rottweil (DE)
(72) Erfinder: Kliem, Thomas, 78628 Rottweil (DE)
(74) Vertreter: Düsselberg, David

(57) **Zusammenfassung**

Die Erfindung betrifft ein Halbleiterleistungsrelais, insbesondere KFZ-Halbleiterleistungsrelais, mit wenigstens einem Gehäuse, einer im Inneren des Gehäuses angeordneten Leiterplatte aufweisend eine Leistungstransistorschaltung und einem teilweise im Gehäuse angeordneten Hochstromkontakt, welcher mit der Leiterplatte mittels eines ersten Kontaktelements leitungstechnisch verbunden ist, wobei der Hochstromkontakt über ein zweites Kontaktelement zur leitungstechnischen Verbindung der Leistungstransistorschaltung mit einer Leiterplatte eines externen Stromkreises, insbesondere dem Bordnetz eines Kraftfahrzeugs, verfügt, welches eine Vielzahl von Löt- und/oder Einpressstifte aufweist, wobei das zweite Kontaktelement durch eine erste Öffnung in der Wand des Gehäuses derart hindurch geführt ist, dass die Löt- und/oder Einpressstifte außerhalb des Gehäuses angeordnet sind.

Ferner betrifft die Erfindung ein Verfahren zur Verbindung eines Halbleiterleistungsrelais mit einer Leiterplatte eines KFZ-Bordnetzes.

## Beschreibung

Die Erfindung betrifft Halbleiterleistungsrelais mit einem Hochstromkontakt zur elektrischen Verbindung einer Leiterplatte des Halbleiterleistungsrelais mit einer Leiterplatte eines externen Stromkreises, insbesondere dem elektrischen Bordnetz eines Kraftfahrzeugs. Ferner betrifft die Erfindung ein Verfahren zur Verbindung des Halbleiterleistungsrelais gemäß der Erfindung mit der Leiterplatte eines externen Stromkreises, insbesondere dem elektrischen Bordnetz eines Kraftfahrzeugs.

Im technischen Bereich der Fahrzeugelektronik werden zur Schaltung von hohen Strömen zwischen 50A und 1000A mit Spannungsbereichen von 12V, 24V, 48V, 60V oder 80V kontaktbehaftete, mechanische Leistungsrelais eingesetzt. Mechanische Leistungsrelais sind im Kern aus einem Permanentmagneten, einem beweglichen Kontakt und einer elektrischen Spulenanordnung gebildet.

Mechanische Leistungsrelais haben jedoch eine Reihe von Nachteilen. Sie haben insbesondere eine begrenzte Anzahl von Schaltzyklen, welche bei ungünstig zu schaltenden Lasten wenige 1000 Schaltzyklen betragen kann. Weitere Nachteile sind die Anfälligkeit gegenüber Einschaltströmen und Spannungsspitzen, die geringe Vibrations- und Schockresistenz sowie die vergleichsweise hohe Wärmeentwicklung, welche gesonderte Kühlmaßnahmen erfordert. Auch lassen sich mechanische Leistungsrelais hinsichtlich ihres Leistungsdaten schlecht skalieren und an bestimmte elektrische Kennwerte baulich anpassen. Darüber hinaus benötigt ein mechanisches Leistungsrelais einen vergleichsweise hohen Spulenstrom sowie zur Schaltung eine Spannung die im Wesentlichen der Nennspannung entspricht.

Darüber hinaus sind aus dem Kraftfahrzeugbereich Halbleiterrelais bekannt, die für verschiedene Anwendungen im Niederstrombereich genutzt werden. Hierzu zählen beispielsweise Blinkerrelais als Taktgeber für die Blinkleuchte oder Intervallrelais zur Steuerung von Scheibenwischerintervallen. Halbleiterrelais sind keine mechanischen Relais, sondern elektronische Bauelemente, die ohne bewegte Kontakte schalten. Sie werden in der Regel mit Transistoren wie etwa Feld-Effekt-Transistoren (FET) realisiert.

Im Gegensatz zu mechanischen Leistungsrelais verfügen Halbleiterrelais über nahezu unbegrenzte Schaltzyklen, können mit hohen Einschaltströmen oder Spannungsspitzen belastet werden, weisen eine hohe Vibrations- und Schockresistenz und entwickeln aufgrund der geringen Leistungsaufnahme bei der Ansteuerung nur eine geringe Eigenwärme, wodurch auf gesonderte Kühlmaßnahmen verzichtet werden kann.

Aufgrund dieser Vorteile besteht mithin das prinzipielle industrielle Bestreben, mechanische Leistungsrelais durch halbleiterbasierte Leistungsrelais, kurz Halbleiterleistungsrelais, zu ersetzen. Dies ist jedoch bislang an verschiedenen Problemen gescheitert, die insbesondere die Verbindung zwischen Hochstromkontakt und Leiterplatte einerseits und zwischen Hochstromkontakt und KFZ-Bordelektronik andererseits betreffen.

Im Allgemeinen sind Hochstromkontakte bekannt und werden aufgrund ihrer guten elektrischen Eigenschaften dazu verwendet, hohe Ströme zu übertragen. Diese reichen typischerweise von einigen Ampere bis zu einigen hundert Ampere. Ebenso eignen Sie sich für die Einspeisung hoher Gleich- und Wechselspannungen. Auf dem Markt verfügbare Hochstromkontakte haben sich jedoch mit Blick auf den angestrebten Ersatz von mechanischen Leistungsrelais als funktional wenig flexibel erwiesen.

Allerdings bereitet die Montage von Halbleiterleistungsrelais auf bordnetzseitig zum Anschluss bereitgestellten Leiterplatten Schwierigkeiten. Dies insbesondere deshalb, da eine Montage als Baugruppe bislang nicht möglich ist. Stattdessen ist eine Montage von Einzelkomponenten, wie etwa Hochstromkontakt, interne Leiterplatte und Gehäuse in mehren Schritten erfolgen. Im Unterschied zu mechanischen Leistungsrelais, die in einem Schritt aufgesteckt werden konnten, besteht hier Verbesserungsbedarf.

Der Erfindung liegt damit die **Aufgabe** zugrunde, ein Halbleiterleistungsrelais und ein Verfahren, bereitzustellen, welches die Verbindung mit bordnetzseitigen Stromanschlüssen erleichtert.

Zur **Lösung** der Aufgabe wird mit der Erfindung ein Halbleiterleistungsrelais, insbesondere KFZ-Halbleiterleistungsrelais, vorgeschlagen, mit wenigstens einem Gehäuse, einer im Inneren des Gehäuses angeordneten Leiterplatte aufweisend eine Leistungstransistorschaltung und einem teilweise im Gehäuse angeordneten Hochstromkontakt, welcher mit der Leiterplatte mittels eines ersten Kontaktelements leitungstechnisch verbunden ist, wobei der Hochstromkontakt über ein zweites Kontaktelement zur leitungstechnischen Verbindung der Leistungstransistorschaltung mit einer Leiterplatte eines externen Stromkreises, insbesondere dem Bordnetz eines Kraftfahrzeugs, verfügt, welches eine Vielzahl von Löt- und/oder Einpressstifte aufweist, wobei das zweite Kontaktelement durch eine erste Öffnung in der Wand des Gehäuses derart hindurchgeführt ist, dass die Löt- und/oder Einpressstifte außerhalb des Gehäuses angeordnet sind.

Ferner wird zur **Lösung** der Aufgabe vorgeschlagen ein Verfahren zur Verbindung eines Halbleiterleistungsrelais mit einer Leiterplatte eines KFZ-Bordnetzes, wobei ein Halbleiterleistungsrelais gemäß der Erfindung als fertige Baugruppe mit der Leiterplatte mechanisch und leitungstechnisch verbunden wird, wobei mittels eines Presswerkzeugs eine in Richtung der Leiterplatte entlang der Längsachse der Einpressstifte des zweiten Kontaktelements gerichtete Kraft auf den Kraftaufnahmeabschnitt des Hochstromkontakts und/oder des Gehäuses eingebracht wird, wobei die Einpressstifte des zweiten Kontaktelements in korrespondierende Stiftaufnahmen der Leiterplatte des KFZ-Bordnetzes eingepresst werden.

Durch die Erfindung ist es nun erstmals möglich, die im KFZ-Elektronikbereich bislang eingesetzten mechanischen kontaktbehafteten Leistungsrelais durch Halbleiterleistungsrelais zu ersetzen. Dies wird im ersten Schritt durch das erfindungsgemäße Halbleiterleistungsrelais erreicht, welches einerseits mit seinem zweiten Kontaktelement einen bordnetzkompatiblen Relaisanschluss bereitstellt, der hinsichtlich Geometrie, Abmessung und Leistungsaufnahme demjenigen der bisher verwendeten mechanischen Relais entspricht. Auf einen für ein mechanisches Leistungsrelais vorgesehen Bordnetzanschluss, insbesondere in Form einer der Stromverteilung dienenden Leiterplatte, kann nun das Halbleiterleistungsrelais als fertige Baugruppe mittels des zweiten Kontaktelements des Hochstromkontakts in einfacher Weise in einem Schritt eingepresst bzw. aufgelötet werden. Dies wird dadurch erreicht, dass das Gehäuse eine Öffnung bereitstellt, durch die das zweite Kontaktelement welches die Leistungselektronik im Inneren des Gehäuses bestimmungsgemäß mit dem Bordnetz verbindet, von außen zugänglich ist, so dass das Halbleiterleistungsrelais als fertige Baugruppe auf der Leiterplatte des Bordnetzes entweder mittels Löten oder Einpressen in einem Schritt montiert werden kann. In Vorteilhafterweise entfällt hierdurch die aufwändige gesonderte Montage der Einzelkomponenten. Ein Ersatz von mechanischen Leistungsrelais ist daher in tatsächlicher Hinsicht durch die Erfindung erreicht.

Ein "Hochstrom" meint im Sinne der Erfindung Ströme mit Stromstärken zwischen 50 A und 1000 A.

"Halbleiterleistungsrelais" meint im Sinne der Erfindung eine diskrete Baugruppe, welche eine elektronische Schaltung aufnimmt, die als wesentliches Funktionselement einen oder mehrere Leistungstransistoren, insbesondere einen Leistungs-MOSFET, aufnimmt. Es verfügt über wenigstens einen elektrischen Kontakt, der mit einem externen Stromkreis leitungstechnisch verbindbar ist und vorzugsweise auf einen korrespondieren Anschluss bspw. ein den externen Stromkreis bereitstellendes Bordnetz eines Kraftfahrzeugs verliersicher montierbar ist.

Der Begriff "Leistungstransistor" bezeichnet im Sinne der Erfindung ein Transistor zum Schalten oder Steuern von Strömen zwischen 50 A und 1000 A. Sie unterscheiden sich von üblichen Transistoren in ihrem Aufbau insbesondere durch ihre geometrische Form und Dimension.

Der Begriff "Leistungs-MOSFET" bezeichnet im Sinne der Erfindung eine Sonderform des Leistungstransistors. "MOSFET" steht für "metal oxide semiconductor field-effect transistor" bzw. "Metall-Oxid-Halbleiter-Feldeffekttransistor" und ist eine Bauform eines Transistors. Innerhalb der Feldeffekttransistoren zeichnen sich MOSFETs durch ein isoliertes Gate aus einem Oxid aus und gehören damit zu den Feldeffekttransistoren mit isoliertem Gate (IGFET) bzw. Metall-Isolator-Halbleiter-Feldeffekttransistoren (MISFET). MOSFETs basieren auf einer Metall-Isolator-Halbleiter-Struktur, d. h. einem schichtweisen Aufbau aus einer isolierten Gate-Elektrode aus Metall oder hochdotiertem Polysilizium, einem Halbleiter und dem dazwischen befindlichen oxidischen Dielektrikum. Die Steuerung des Stromflusses im Halbleiterbereich erfolgt zwischen den beiden elektrischen Anschlüssen Drain und Source über eine elektrische Steuerspannung (Gate-Source-Spannung) bzw. Steuerpotential (Gate-Potential). Auch der Aufbau des Leistungs-MOSFET entspricht im Prinzip dem des MOSFET Die hohe Leistungsdichte wird bei Leistungs-MOSFETs jedoch durch eine raster- oder wabenartige Halbleiterstruktur erreicht, die einer Parallelschaltung von tausenden einzelnen MOSFETs entspricht. Dies wird dadurch ermöglicht, dass sich MOSFETs bei niedrigen Schaltfrequenzen nahezu leistungslos steuern lassen, da lediglich zum Umladen der Gatekapazität impulsweise Steuerströme benötigt werden. Der beim eingeschalteten Transistor verbleibende Widerstand verursacht eine Verlustleistung und besitzt einen positiven Temperaturkoeffizienten, weshalb MOSFETs parallelgeschaltet werden können.

Als "Einpresstechnik" bezeichnet man eine lötfreie Verbindungstechnik bei Leiterplatten, bei der ein Kontaktstift, vorliegend als "Einpressstift" bezeichnet, in das metallisierte Loch einer Leiterplatte gedrückt wird. Hierdurch kann auf zusätzliche mechanische Befestigung verzichtet werden. Vorzugsweise wird die sogenannte massive Einpresstechnik (MPFT) eingesetzt. Hierzu sind die Einpressstifte als massive quadratische Pins ausgebildet. Die Diagonale des Stiftquerschnitts ist größer als der Durchmesser des Lochs in der Leiterplatte. Durch das Einpressen der Kontaktstiftkanten in die Metallisierung der Durchkontaktierung der Leiterplatte entsteht eine gasdichte Kaltschweißverbindung über die Länge der Durchkontaktierung, die sich bei bestimmungsgemäßer Ausführung durch eine sehr hoher Stromtragfähigkeit sowie hohe Zuverlässigkeit und Langlebigkeit auszeichnet.

Gemäß einem bevorzugten Merkmal der Erfindung sind Gehäusewand und Hochstromkontakt wenigstens in Richtung der Längserstreckung der Einpressstifte des zweiten Kontaktelements miteinander bewegungstechnisch derart gekoppelt, dass eine Bewegung des Hochstromkontakts eine Bewegung des Gehäuses und/oder eine Bewegung des Gehäuses eine Bewegung des Hochstromkontakts bewirkt. Soll wie gemäß einer ersten Alternative, das Halbleiterleistungsrelais in die Leiterplatte des Bordnetzes eingepresst werden, bedarf es einer bewegungstechnischen Koppelung zwischen Gehäuse einerseits und Hochstromkontakt andererseits. Die Kraftbeaufschlagung kann dabei über das Gehäuse oder den Hochstromkontakt erfolgen. Es ist dabei bevorzugt vorgesehen, dass der Hochstromkontakt und/oder das Gehäuse einen Kraftaufnahmeabschnitt aufweist, welcher dazu dient, mit einem Pressstempel eines Presswerkzeugs zusammenzuwirken. Es ist dabei bevorzugt, dass das Gehäuse eine zweite Öffnung aufweist, durch welche der Kraftaufnahmeabschnitt des Hochstromkontakts hindurchgeführt ist und/oder das Presswerkzeug in das Gehäuse einführbar und der Kraftaufnahmeabschnitt des Hochstromkontakts und/oder des Gehäuses mit dem Presswerkzeug kontaktierbar ist. Besonderes bevorzugt wird der Hochstromkontakt dabei mit Kraft beaufschlagt. Dies vereinfacht zum einen den Aufbau des Halbleiterleistungsrelais. Zum anderen kann die während des Einpressvorgangs anliegende Presskraft in besonders effizient sowohl auf die Einpressstifte des zweiten Kontaktelements als auch auf das Gehäuse übertragen werden. Ermöglicht wird dies insbesondere durch die erfindungsgemäße Ausgestaltung des Hochstromkontakts.

Es ist in diesem Zusammenhang bevorzugt vorgesehen, dass der Kraftaufnahmeabschnitt des Hochstromkontakts wenigstens teilweise stabförmig, mit insbesondere rundem, vorzugsweise kreisförmigem Querschnitt, ausgebildet ist. Auch eckige Querschnitte können bevorzugt sein, da sie fertigungstechnische Vorteile aufweisen. Er weist vorzugsweise eine Länge von 3 mm bis 20 mm, insbesondere von 5 mm bis 10 mm, auf. Bevorzugt weist er zudem einen Durchmesser von 1 mm bis 5 mm, insbesondere 2 mm bis 4 mm auf. Vorzugsweise erstrecken sich der stabförmige Kraftaufnahmeabschnitt einerseits und die Einpressstifte des zweiten Kontaktelements andererseits voneinander gegenüberliegenden Enden des Hochstromkontakts in entgegengesetzter Richtung vom jeweiligen Ende weg. Vorzugsweise sind Kraftaufnahmeabschnitt einerseits und Einpressstifte andererseits dabei koaxial und/oder auf parallel zueinander verlaufenden Längsachsen angeordnet. Hierdurch wird die Presskraft linear vom Kraftaufnahmeabschnitt auf die Einpressstifte übertragen. Durch diese Ausgestaltung des Hochstromkontakts ist in vorteilhafter Weise eine besonders effiziente Kraftübertragung erreicht.

Vorzugsweise ist der stabförmige Teil des Kraftaufnahmeabschnitts lösbar dem ersten Abschnitt des Hochstromkontakts verbunden. Hierdurch kann der stabförmige Teil zur Montage des Relais auf der zum Bordnetz gehörenden Leiterplatte mit dem ersten Abschnitt verbunden werden. Nach erfolgter Montage, also der Einpressung des zweiten Kontaktelements in die Leiterplatte, kann der stabförmige Teil wieder gelöst werden. Hierdurch wird der Raumbedarf des Hochstromkontakts reduziert, wodurch die Anbindung mehrerer Leiterplatten im Inneren des Gehäuses aus verschiedenen Raumrichtungen erleichtert wird. Zum anderen kann der stabförmige Teil für mehrere Montagevorgänger verschiedener Hochstromkontakte genutzt werden, wodurch Material eingespart werden kann. Darüber hinaus kann die zweite Öffnung des Gehäuses nach Lösung und Entfernung des stabförmigen Teils in einfacher Weise, insbesondere wasserdicht, verschlossen werden. Hierzu ist ein entsprechender Verschluss für die zweite Öffnung vorgesehen. Der erste Abschnitt des Hochstromkontakts weist im Falle der lösbaren Verbindung mit dem stabförmigen Teil des Kraftaufnahmeabschnitts eine sich in axialer Richtung erstreckende Vertiefung auf, die der Aufnahme des einen Endes des stabförmigen Teils dient. Die Vertiefung kann insbesondere bei Ausführung des stabförmigen Teils mit kreisförmigem Querschnitt ein Innengewinde aufweisen, welches mit einem entsprechenden Außengewinde zusammenwirkt, dass am korrespondierenden Ende des stabförmigen teils ausgebildet ist.

Gemäß einem bevorzugten Merkmal der Erfindung ist vorgesehen, dass der Hochstromkontakt wenigstens zwei miteinander verbundene Abschnitte aufweist, wobei der erste Abschnitt das erste Kontaktelement und den Kraftübertragungsabschnitt bereitstellt. Der zweite Abschnitt stellt hingegen das zweite Kontaktelement bereit. Vorzugsweise bilden der erste Abschnitt und/oder der zweite Abschnitt ein Kopplungselement aus. Das Kopplungselement dient der Kraftübertragung während des Einpressvorgangs vom Hochstromkontakt auf das Gehäuse. Vorzugsweise wirkt das Kopplungselement mit einem von der Wand des Gehäuses bereitgestellten korrespondierenden Element in Richtung der Längserstreckung der Einpressstifte des zweiten Kontaktelements formschlüssig zusammen. In besonders vorteilhafter Weise kann die am Kraftaufnahmeabschnitt anliegende Presskraft demgemäß nicht nur in linearer Richtung auf die Einpressstifte übertragen werden, sondern auch auf das Gehäuse. Dies hat sich als besonders effizient herausgestellt. Zudem kann hierdurch ein einfacher Aufbau des Gehäuses erreicht werden, der keine zusätzlichen baulichen Maßnahmen im Innenraum des Gehäuses erfordert. Der hierdurch freiwerdende Platz im Innenraum kann stattdessen für zusätzliche Elektronik genutzt werden. Insbesondere weitere Leistungs-, Steuerungs- oder Diagnoseelektronik.

Hinsichtlich der erfindungsgemäßen Verfahrensführung ist bevorzugt, dass mit einem Pressstempel des Presswerkzeugs auf den stabförmigen Kraftaufnahmeabschnitt des Hochstromkontakts gepresst wird, wobei die dabei auf den Hochstromkontakt wirkende Presskraft von einem Kopplungselement des ersten Abschnitts auf ein von der Wand des Gehäuses bereitgestelltes korrespondierendes Element übertragen wird, wobei während des Pressvorgangs ein Formschluss zwischen dem Kopplungselement und dem korrespondierenden Element hergestellt wird.

Besonders bevorzugt ist dabei vorgesehen, dass das Kopplungselement von einer, insbesondere umlaufenden, Randfläche des ersten Abschnitts gebildet ist und dass das korrespondierende Element von einer, insbesondere umlaufenden, Randfläche der Innenwand des Gehäuses gebildet ist, die die erste Öffnung innenraumseitig einfasst. Zur Ausbildung der Randfläche ist vorgesehen, dass der erste Abschnitt eine größere Querschnittsfläche aufweist als der zweite Abschnitt. Ferner ist bevorzugt vorgesehen, dass die Querschnittsfläche des ersten Abschnitts größer ist, als die Querschnittsfläche der ersten Öffnung. Konstruktiv ist der zweite Abschnitt dabei teilweise innerhalb der ersten Öffnung und Randfläche des ersten Abschnitts vollständig im Innenraum des Gehäuses angeordnet.

Zur weiteren Verbesserung der Kraftübertragung während des Einpressens ist bevorzugt vorgesehen, dass der stabförmige Kraftaufnahmeabschnitt, der erste Abschnitt und der zweite Abschnitt des Hochstromelements hinsichtlich ihrer jeweiligen Längserstreckung auf einer gemeinsamen Längsachse, mithin koaxial, angeordnet sind.

Gemäß einem bevorzugten Merkmal der Erfindung ist vorgesehen, dass das erste Kontaktelement zur leitungstechnischen Verbindung mit der Leiterplatte eine Vielzahl von Löt- und/oder Einpressstiften aufweist. Bevorzugt ist zur Verbindung mit der internen Leiterplatte ebenfalls das Einpressverfahren. Im Unterschied zum Löten kann die Herstellung des Halbleiterleistungsrelais zumindest teilweise automatisiert werden.

Es ist überdies bevorzugt vorgesehen, dass der erste Abschnitt wenigstens ein weiteres Kontaktelement in Form einer Vielzahl von Löt- und/oder Einpressstiften, bevorzugt Einpressstifte, zur leitungstechnischen Verbindung mit einer weiteren Leistungstransistorschaltung aufweist. Die Leistungstransistorschaltung kann dabei von einer weiteren im Innenraum des Gehäuses angeordneten Leiterplatte bereitgestellt werden. Alternativ oder zusätzlich kann die weitere Leistungstransistorschaltung von einer einzigen Leiterplatte bereitgestellt werden, die sich in drei Raumrichtungen erstreckt. Es ist dabei bevorzugt, dass sich die Löt- und/oder Einpressstifte des weiteren Kontaktelements in Längsrichtung in einem Winkel relativ zu den Löt- und/oder Einpressstiften des ersten Kontaktelements erstrecken. Hierdurch wird die leitungstechnische Verbindung und damit Parallelschaltung von mehreren Leistungstransistorschaltung ermöglicht.

Hierdurch ist es nun erstmals möglich, Halbleiterleistungsrelais in nahezu beliebiger Weise für Hochstromanwendungen zu skalieren. Erreicht wird dies, indem der Hochstromkontakt mit seinem im Inneren des Gehäuses angeordneten ersten Abschnitts mehr als einen Anschluss für Leiterplatten bereitstellt. Hierdurch können wenigstens zwei, vorzugsweise jedoch mehrere Leistungstransistoren parallelgeschaltet werden. Dies kann dadurch erfolgen, dass auf einer einzigen dreidimensionalen Leiterplatte zwei oder mehr Leistungstransistoren angeordnet und mittels der verschiedenen Kontaktelemente, insbesondere der verschiedenen freien Polyederflächen, insbesondere Quaderflächen, leitungstechnisch mit dem externen Stromkreis, insbesondere dem Bordnetz, verbunden werden. Die Parallelschaltung wird durch eine entsprechende Leitungsführung auf der Leiterplatte realisiert. Zusätzlich zu dieser Möglichkeit oder auch alternativ dazu können Leistungstransistoren auf verschiedenen Leiterplatten angeordnet sein. In diesem Fall lassen sich die verschiedenen Leiterplatten mittels der vom ersten Abschnitt des Hochstromkontakts bereitgestellten Kontaktelemente parallelschalten. Auf diese Weise ist es dem erfindungsgemäßen Halbleiterleistungsrelais möglich, besonders hohe Ströme zu schalten und durch entsprechende Parallelschaltung in Abhängigkeit der zu schaltenden Stromstärken skaliert zu werden. Dies wird insbesondere durch die bevorzugte innovative geometrische Struktur und Form des ersten Abschnitts ermöglicht, bei der winklig zueinanderstehende freie Polyederflächen, insbesondere Quaderflächen, den Anschluss von Leiterplatten in drei Dimensionen erlaubt. Ein weiterer Vorteil der Erfindung ist, dass besonders kurze Leitungswege zwischen den zu den Kontaktelementen korrespondierend ausgebildeten Kontaktflächen der Leiterplatte und dem auf der Leiterplatte befindlichen Leistungstransistor-Bauelement realisierbar sind. Hierdurch werden übermäßige Spannungsabfälle und Wärmeentwicklung aufgrund von Leitungswiderständen vermieden. Diese kurzen Leitungswege werden wiederum aufgrund der Geometrie des ersten Abschnitts des Hochstromkontakts realisierbar, da die Anordnung von Kontaktflächen, Leitungswegen und Transistor-Bauelementen auf einer oder mehreren Leiterplatten unmittelbar nebeneinander erfolgen kann. Darüber hinaus können aufgrund der kurzen Wege erforderliche EMV- und ESD-Schutzbausteine unmittelbar an den Kontaktflächen angeordnet werden, wodurch diese besonders wirksam sind.

Gemäß einem bevorzugten Merkmal der Erfindung ist es daher vorgesehen, dass der erste Abschnitt polyedrisch, insbesondere quaderförmig, bevorzugt kubisch, ausgebildet ist. Vorzugsweise ist dabei eine der Polyederflächen, insbesondere Quaderflächen, insbesondere Kubusflächen, mit dem zweiten Abschnitt verbunden. Die übrigen Polyederflächen, insbesondere Quaderflächen, insbesondere Kubusflächen bilden hingegen freie Polyederflächen, insbesondere Quaderflächen, insbesondere Kubusflächen. Vorzugsweise vorgesehen ist, dass jeweils auf einer freien Polyederfläche, insbesondere Quaderfläche, insbesondere Kubusfläche, jeweils ein Kontaktelement angeordnet ist. Vorzugsweise stehen die Einpressstifte des jeweiligen Kontaktelements dabei jeweils lotrecht auf der jeweiligen freien Polyederfläche, insbesondere Quaderfläche, insbesondere Kubusfläche. Weiter bevorzugt ist der Kraftaufnahmeabschnitt des Hochstromkontakts von der freien Polyederfläche, insbesondere Quaderfläche, insbesondere Kubusfläche, gebildet oder darauf angeordnet, die derjenigen Polyederfläche, insbesondere Quaderfläche, insbesondere Kubusfläche, gegenüberliegend angeordnet ist, die mit dem zweiten Abschnitt des Hochstromkontakts verbunden ist. Durch die bevorzugte Ausgestaltung der Erfindung wird einerseits die Parallelschaltung der Leistungselektronik im Inneren des Gehäuses und andererseits die Montage des gesamten Halbleiterleistungsrelais als diskrete Baugruppe auf der bordnetzseitigen Leiterkarte mittels Einpressens ermöglicht. Diese Kombination ermöglicht in vorteilhafter Weise den vollständigen Ersatz von mechanischen Leistungsrelais. Einerseits in Montagehinsicht, andererseits hinsichtlich der Hochstromeignung.

"Polyeder", "polyedrisch" oder "polyedrische Form" bezeichnet im Sinne der Erfindung einen dreidimensionalen Körper, der ausschließlich von ebenen Flächen begrenzt wird. Hierzu zählen vorzugsweise die fünf platonischen Körper Tetraeder, Hexaeder, Oktaeder, Dodekaeder und Ikosaeder, aber auch insbesondere der Quader als allgemeinere Form des platonischen Hexaeders oder Pyramiden mit polygonaler Grundfläche, insbesondere quadratischer Grundfläche. "Quader" bezeichnet im Sinne der Erfindung einen geometrischen Körper, der von 6 Rechtecken begrenzt wird. Er besitzt sechs rechteckige Seitenflächen, die im rechten Winkel aufeinander stehen, und vorliegend als "Quaderflächen" bezeichnet werden, acht rechtwinklige Ecken und 12 Kanten, von denen jeweils vier gleiche Längen besitzen, zueinander parallel sind und vorliegend als "Quaderkanten" bezeichnet werden. Gegenüberliegende Seitenflächen eines Quaders sind parallel und deckungsgleich. Im Sonderfall gleicher Kantenlängen, bei dem alle Seitenflächen des Quaders Quadrate sind, ergibt sich im Sinne der Erfindung einen Kubus, also einen platonischen Hexaeder.

Gemäß einem bevorzugten Merkmal der Erfindung ist vorgesehen, dass jedes Kontaktelement auf einer separaten Polyederseite angeordnet ist und sich entlang der Flächennormalen der jeweiligen Polyederfläche erstreckt. In vorteilhafter Weise kann dann der interne leiterplattenseitige Anschluss an den Hochstromkontakt damit an verschiedenen Seiten des Polyeders erfolgen, wodurch insbesondere die Anordnung von zwei oder mehr Leiterplatten aufgrund der räumlichen Trennung der Anschlüsse erleichtert ist.

Vorzugsweise ist vorgesehen, dass der Abschnitt kubisch ausgebildet ist. Dabei sind bevorzugt wenigstens zwei freie Kubusflächen mit Kontaktelementen in Form einer Vielzahl von Einpressstiften bestückt. Dies ermöglicht die Parallelschaltung wenigstens zweier Leistungstransistoren auf einer oder verschiedenen Leiterplatten mit den erfindungsgemäßen Vorteilen. Je nachdem welche der freien Kubusflächen mit Kontaktelementen bestück sind, ergeben sich verschiedene Vorteile.

Gemäß einer ersten bevorzugten Ausgestaltung sind die beiden mit Kontaktelementen bestückten freien Kubusflächen einander gegenüberliegend angeordnet. Dies erleichtert die Verbindung des ersten Abschnitts mit zwei zweidimensionalen Leiterplatten. Diese können, ohne sich im Raum zu blockieren an gegenüberliegenden Seiten des Kubus angeordnet und über die jeweiligen Kontaktelemente leitungstechnisch verbunden und mechanisch befestigt werden. Hierbei ergibt sich im Ergebnis eine Anordnung aus zwei zweidimensionalen Leiterplatten und einen zwischengeordneten Hochstromkontakt, bei dem die beiden flächigen Ebenen der Leiterplatten zueinander parallel verlaufen.

Gemäß einer zweiten bevorzugten Ausgestaltung ist vorzugsweise vorgesehen, dass die beiden mit Kontaktelementen bestückten freien Kubusflächen eine gemeinsame Kante zwischen sich ausbilden und sich im rechten Winkel zueinander erstrecken. Diese winklige Ausgestaltung der freien Kubusflächen und korrespondierenden Kontaktelementen erlaubt die einfachste dreidimensionale Ausgestaltung der Leiterplatte mit einfach gewinkeltem Querschnitt und erlaubt überdies den Anschluss des Hochstromkontakts an die Leiterplatten mittels Einpresstechnik. Dies deshalb, da im vorliegenden Fall die den jeweils mit Kontaktelementen bestückten Kubusflächen gegenüberliegenden Kubusflächen kontaktelementfrei ausgebildet sein können und damit der Kraftaufnahme und Kontaktierung mit einem Einpresswerkzeug, etwa in Form eines Pressstempels dienen können. Die Presskraft kann in diesem Fall linear auf den Hochstromkontakt gelegt werden, wodurch eine unerwünschte mechanische Beanspruchung der Einpressstifte quer zur deren jeweiliger Einpressrichtung vermieden wird.

Gemäß einem weiteren bevorzugten Merkmal der Erfindung ist vorgesehen, dass eine der mit Einpressstiften bestückten freien Kubusflächen derjenigen Kubusfläche gegenüberliegend angeordnet ist, die mit dem zweiten Abschnitt verbunden ist. Der Vorteil dieser weitergebildeten Ausführungsform der gewinkelten Ausrichtung der mit Kontaktelementen bestückten freien Quaderflächen liegt darin, dass das zweite Ende als Kraftaufnahmeabschnitt für die Einpresstechnik genutzt werden kann, was zu einer besonders günstigen Krafteinleitung führt. Die betreffende Kubusfläche stellt neben den Kontaktelementen dann vorzugsweise auch die Kraftaufnahmeabschnitt bereit. Entweder kann das Presswerkzeug direkt auf die Einpressstifte des weiteren Kontaktelements aufgesetzt werden, welche dann selbst den Kraftaufnahmeabschnitt bilden oder auf der betreffenden Kubusfläche ist neben den Einpressstiften der stabförmige Kraftaufnahmeabschnitt, insbesondere im Zentrum der Kubusfläche, angeordnet.

Gemäß einem bevorzugten Merkmal der Erfindung ist vorgesehen, dass mehr als nur zwei freie Kubusflächen mit Kontaktelementen bestückt sind. Je mehr freie Flächen bestückt sind, desto höher können die zu schaltenden Ströme sein, da im Ergebnis mehr Leistungstransistoren parallelgeschaltet werden können. Um eine an den konkreten Anwendungsfall angepasste Skalierung zu erreichen können 3, 4 oder alle 5 freien Flächen mit Kontaktelementen bestückt und leitungstechnisch über das zweite Kontaktelement des zweiten Abschnitts mit dem Bordnetz elektrisch verbindbar sein. Aus der Anzahl der zur Kontaktierung nutzbaren freien Flächen des ersten Abschnitts ergeben sich eine Vielzahl von leiterplattenseitigen Schaltungsmöglichkeiten. Dabei können bis zu fünf zweidimensionale Leiterplatten mittels des Hochstromkontakts leitungstechnisch verbunden werden. Alternativ kann eine entsprechend ausgebildete dreidimensionale Leiterplatte an bis zu fünf Kontaktabschnitten mit dem Hochstromkontakt leitungstechnisch verbunden werden. Auch eine kombinierte Ausgestaltung einer leitungstechnischen Verbindung des Hochstromkontakts mit zweidimensionalen und dreidimensionalen Leiterplatten ist möglich und bevorzugt. Besonders bevorzugt ist, dass alle fünf freien Flächen jeweils ein Kontaktelement in Form einer Vielzahl von Löt- und/oder Einpressstiften, insbesondere Einpressstiften, aufweisen, die lotrecht auf der jeweiligen freien Fläche stehen und innerhalb eines vorgebbaren Flächenabschnitts der jeweiligen freien Fläche regelmäßig verteilt angeordnet sind.

Die Bezeichnung "Flächenabschnitt" umfasst im Sinne der Erfindung die gesamte Fläche oder nur einen Teil davon. Sofern ein Teil gemeint ist, weist der Flächenabschnitt einen rechteckigen Umfang auf. Die Fläche eines Flächenabschnitts der mit Einpressstiften bestückt ist, kann insbesondere zwischen 25% und 75%, insbesondere 40% bis 60%, vorzugsweise 45% bis 55%, besonders bevorzugt 50%, der Gesamtfläche betragen. Ferner ist es bevorzugt, dass ein umlaufender freier Rand gebildet ist, der frei von Einpressstiften ist. Der hat vorzugsweise eine Breite die der Breite (im Fall von Einpressstiften mit eckigem Querschnitt) bzw. dem Durchmesser (im Fall von Einpressstiften mit kreisförmigem Querschnitt) eines Einpressstifts entspricht. Vorzugsweise beträgt die Breite des freien Randes dabei zwischen 0,5 mm und 1 mm. Hierdurch kann der Rand als Auflagefläche für ein Presswerkzeug bei der Einpresstechnik genutzt werden, ohne dass die äußeren Einpressstifte beschädigt werden, insbesondere abknicken oder verbiegen. Alternativ kann auch beim Einpressen auf den umlaufenden Rand verzichtet und die äußeren Einpressstifte randbündig im Flächenabschnitt platziert werden. In diesem Fall kann beispielsweise über die Einpressstifte direkt eingepresst werden, insbesondere dann, wenn die Kontaktelemente als massive Einpressstifte mit rechteckigem, insbesondere quadratischem, oder rundem, insbesondere kreisförmigem, Querschnitt gebildet sind.

Gemäß einem bevorzugten Merkmal der Erfindung ist vorgesehen, dass in den Hochstromkontakt eine Leistungsleitung zur elektrischen Ansteuerung eines Leistungstransistors auf der Leiterplatte des Halbleiterleistungsrelais und eine Signalleitung für die datentechnische Verbindung mit Diagnoseeinheiten integriert sind, wobei für die jeweilige Verbindung Kontaktelemente verschiedener freier Polyederflächen, insbesondere Quaderflächen, insbesondere Kubusflächen, und/oder einzelne Einpressstifte und/oder eine Mehrzahl von Einpressstiften der gleichen Polyederfläche, insbesondere Quaderfläche, insbesondere Kubusfläche, zu wenigstens einer Leistungsleitungsgruppe und einer Diagnoseleitungsgruppe gruppiert sind. Der Hochstromkontakt bündelt damit verschiedene Funktionen. Hierdurch entfallen separate Baugruppen, wodurch Platz auf der Leiterplatte für anderes frei wird. Darüber hinaus können auf diesem Wege verschiedenste Diagnosedaten und elektrische Kennwerte über den Hochstromkontakt und/oder die Leistungstransistorschaltung erhalten und ausgewertet werden. Es ist in diesem Zusammenhang bevorzugt, dass der erste Abschnitt des Hochstromkontakts mehrteilig ausgebildet ist. Die einzelnen Teile sind dabei derart miteinander verbunden, dass sie zusammengenommen die Polyederform, insbesondere Quaderform, insbesondere Kubusform, des ersten Abschnitts ausbilden. Ferner ist bevorzugt vorgesehen, dass die jeweiligen Teilflächen mit Einpressstiftgruppen ausgerüstet sind, wobei bei beistimmungsgemäßer Zusammenfügung der Teile die Teilflächen die mit Einpressstiften bestückten Flächenabschnitte ausbilden. Den verschiedenen Einpressstiftgruppen bilden dabei vorzugsweise entweder die jeweilige Leistungsleitung oder die jeweilige Signalleitung.

Gemäß einem bevorzugten Merkmal der Erfindung ist vorgesehen, dass die wenigstens zwei freien Quaderflächen, insbesondere Kubusflächen, vorzugsweise 3, 4 oder 5 freie Quaderflächen, insbesondere Kubusflächen, jeweils eine Vielzahl von Einpressstiften, insbesondere bis zu 56, vorzugsweise bis zu 49, aufweisen, die rasterförmig in Reihen und Spalten, insbesondere in der Konfiguration 7x8 bzw. 7x7, in dem jeweils vorgebbaren Flächenabschnitt angeordnet sind, wobei der jeweilige Flächenabschnitt, gegebenenfalls mit Ausnahme eines jeweils umlaufenden Randes, die gesamte jeweilige Quaderfläche, insbesondere Kubusfläche, einnimmt. Ein solcher Hochstromkontakt ist auf maximale Stromtragfähigkeit ausgelegt und dazu geeignet, Ströme von bis zu 1000 A zu leiten und darüber hinaus, insbesondere bei Belegung mit unterschiedlichen Leitungen über Einpressstiftgruppen, neben der eigentlichen Leistungsfunktionalität verschiedene auf den Leiterkarten befindliche Diagnosebausteine anzusteuern. Die Einpressstifte sind dabei vorzugsweise als massive Einpressstifte mit quadratischem oder rundem Querschnitt ausgebildet. Es können jedoch in Abhängigkeit der Stromstärke des zu leitenden Stroms und des gewünschten Funktionsumfangs auch weniger als die Maximalbelegung an Einpressstiften vorgesehen sein. Tatsächlich ist im Wesentlichen jede beliebige Auswahl an Einpressstiften aus der Vielzahl der verfügbaren Einpressstifte, insbesondere den bis zu 56, vorzugsweise den bis zu 49, einer Quaderfläche, insbesondere Kubusfläche, möglich. So können verschiedenste Belegungen realisiert werden. Eine flexible Anpassung an das jeweilige Schaltungsdesign und die zu leitenden Ströme kann hierdurch in vorteilhafter Weise erreicht werden. Es können besonders bevorzugt 4x4 oder 5x5 Raster mit resultierenden 16 bzw. 25 Einpressstiften realisiert werden. Ebenso ist es möglich einzelne oder mehrere Reihen und/oder Spalten mit Einpressstiften zu bestücken. Insbesondere können die jeweils äußeren zwei Spalten und die jeweils äußeren zwei Reihen bestückt werden, um eine umlaufende Reihe aus Einpressstiften zu erhalten.

Durch das erfindungsgemäße Halbleiterleistungsrelais und den erfindungsgemäßen Hochstromkontakt lassen sich verschiedene Relaisausführungen realisieren. Bevorzugt sind Ausgestaltungen als Schließer, Wechsler oder Doppelschließer. Dies bestimmungsgemäße Funktion lässt sich einerseits durch die Anzahl der aus dem Gehäuse geführten Hochstromkontakte und andererseits durch die Anzahl der an die Hochstromkontakte über die internen Leiterplatten angeschlossenen Leistungstransistoren einstellen. Für ein Schließer-Relais sind insbesondere zwei erfindungsgemäße Hochstromkontakte vorgesehen. Für eine Ausführung als Wechsler- oder Doppelschließer-Relais sind demgegenüber drei oder mehr erfindungsgemäße Hochstromkontakte erforderlich, die erfindungsgemäß mit Leistungstransistoren des Relais verbunden, erfindungsgemäß aus dem Gehäuse geführt und erfindungsgemäß mit der Leiterplatte des Bordnetzes leitungstechnisch verbunden sind.

Mit Bezug auf das erfindungsgemäße Halbleiterleistungsrelais ist bevorzugt vorgesehen, dass das Gehäuse einen als Stranggussprofil ausgebildeten Gehäusekörper, insbesondere mit außenseitigen Kühlrippen, aufweist, welcher einen Innenraum und den Innenraum nach außen hin begrenzende Gehäusewände bereitstellt. Im Innenraum sind die Leiterplatte mit der Leistungselektronik und der erste Abschnitt des Hochstromkontakts angeordnet. Das zweite Kontaktelement des zweiten Abschnitts ist außerhalb des Gehäuses angeordnet. Das Gehäuse, genauer der Gehäusekörper, stellt zu diesem Zweck eine erste Öffnung bereit, welche eine Wand des Gehäuses, insbesondere des Gehäusekörpers, vollständig durchgreift. Durch die Ausbildung des Gehäusekörpers als Stranggussprofil mit Kühlrippen, wird die notwendige Ableitung der beim Betrieb des Halbleiterleistungsrelais entstehenden Wärme gewährleistet. Das Gehäuse, insbesondere der Gehäusekörper, stellt bevorzugt eine zweite Öffnung bereit, welche in der Gehäusewand ausgebildet ist, die derjenigen Gehäusewand, welche die erste Öffnung ausbildet, gegenüberliegt. Auch die zweite Öffnung durchgreift die Gehäusewand vollständig. Sie dient entweder dazu, dass ein Pressstempel eines Presswerkzeugs durch die zweite Öffnung hindurchgeführt und der Kraftaufnahmeabschnitt des Hochstromkontakts im Innenraum des Gehäuses mit einer Presskraft beaufschlagt werden kann. Alternativ dient sie dazu, dass der vorzugsweise stabförmig ausgebildete Kraftaufnahmeabschnitt auf dem Gehäuse herausgeführt werden kann. Das freie Ende des stabförmigen Kraftaufnahmeabschnitts ist in diesem Fall außerhalb des Gehäuses angeordnet und für ein Presswerkzeug damit frei zugänglich. Hierdurch wird das Einpressverfahren vereinfacht, da kein auf den Hochstromkontakt abgestimmtes Presswerkzeug verwendet werden muss, welches hinsichtlich seiner Dimensionierung durch die zweite Öffnung passen muss. Stattdessen kann in vorteilhafter Weise ein herkömmliches Presswerkzeug verwendet werden.

Der zweite Abschnitt des Halbleiterleistungsrelais kann vorzugsweise mit rundem oder eckigem Querschnitt ausgebildet sein. Die erste Öffnung hat vorzugsweise eine hierzu korrespondierende Querschnittsform. Das zweite Kontaktelement ist vorzugsweise auf der dem ersten Abschnitt abgewandten Seite angeordnet. Es befindet sich erfindungsgemäß außerhalb des Gehäuses. Der übrige Teil des zweiten Abschnitts ist bestimmungsgemäß innerhalb der ersten Öffnung angeordnet. Der zweite Abschnitt stellt vorzugsweise eine. insbesondere umlaufende, Aufnahmefläche, insbesondere einen Flansch, zur Anordnung eines Strommessgeräts, insbesondere für eine Induktionsspule eines Strommessgeräts, bereit. Die Induktionsspule ist dabei vorzugsweise in die die erste Öffnung bereitstellende Wand des Gehäuses integriert. Sie weist dabei vorzugsweise eine Hülle aus einem Dichtmaterial, welches den Innenraum gegenüber Fremdstoffen, insbesondere Flüssigkeiten, insbesondere Wasser, abdichtet. Alternativ kann die Spule auch vollständig im Gehäuseinnenraum angeordnet sein. In diesem Fall ist in der Gehäusewand eine separate Dichtung vorgesehen.

Eine separate Dichtung ist auch in den Fällen bevorzugt, in denen kein Strommessgerät vorgesehen ist. Aufgrund des Umstandes, dass der Hochstromkontakt aus dem Relaisgehäuse herausgeführt ist, ist es sinnvoll, die Öffnung gegenüber Fremdstoffen, insbesondere Wasser, insbesondere Flüssigkeiten, insbesondere Wasser, abzudichten. Der Einsatz einer Ringdichtung, insbesondere aus Gummi oder PVC ist, bevorzugt. Die Dichtung ist vorzugsweise innerhalb der ersten Öffnung, zwischen dem zweiten Abschnitt und dem die Öffnungswand bildenden Gehäuserand angeordnet.

Das Halbleiterleistungsrelais gemäß der Erfindung kann einteilig oder zweiteilig ausgebildet sein. Bei der einteiligen Ausgestaltung umfasst die Leistungstransistorbaugruppe den Leistungsteil und die Ansteuerung. Der Platzbedarf ist hierdurch geringer. Allerdings muss in diesem Fall, im Vorfeld bekannt sein, wie die Leistungstransistorbaugruppe angesteuert werden soll. Vorzugsweise ist der Steuerungsstromkreis nach dem Vorbild des Leistungsstromkreises mittels eines separaten erfindungsgemäßen Hochstromkontakts mit der zum Bordnetz gehörenden Leiterplatte verbunden. Dabei ist der Hochstromkontakt mit der internen, den Leistungstransistor tragenden, Leiterplatte mittels eines ersten Kontaktelements leitungstechnisch verbunden. Über ein zweites Kontaktelement ist er zur steuerungstechnischen Verbindung der Leistungstransistorschaltung mit einer Leiterplatte eines externen Steuerungsstromkreises, insbesondere dem Bordnetz eines Kraftfahrzeugs, verbunden. Der Hochstromkontakt weist hierzu eine Vielzahl von Löt- und/oder Einpressstifte auf. Das zweite Kontaktelement ist dabei durch eine weitere, gesonderte Öffnung in der Wand des Gehäuses derart hindurchgeführt, dass die Löt- und/oder Einpressstifte außerhalb des Gehäuses angeordnet sind.

Alternativ kann das Halbleiterleistungsrelais zweiteilig ausgebildet sein. In diesem Fall sind Leistungsteil und Ansteuerung voneinander getrennt. Die Ansteuerung ist in ein gesondertes Modul ausgegliedert, dass im Nachgang aufgesteckt werden und entsprechend den Anforderungen konfiguriert werden kann. Hierdurch kann eine Steuerung über Spannungs- / Stromsignale oder digitale Werte implementiert werden. Eine PWM-Ansteuerung oder Strombegrenzung als Leitungsschutz sind ebenfalls realisierbar. Hierdurch kann eine vorteilhafte galvanische Trennung der Ansteuerung, insbesondere über Optokoppler, induktive oder optische Signale, erreicht werden. Zusätzlich oder alternativ ist eine Kopplung mit Bussystemen wie zum Beispiel CAN/LI N/Ethernet herstellbar. Das Modul stellt zur Aufnahme der Steuerungselektronik vorzugsweise ein eigenes Gehäuse bereit.

Vorzugsweise weist das Halbleiterleistungsrelais eine Diagnoseeinrichtung auf. Diese kann insbesondere über den gleichen oder einen separaten Hochstromkontakt mit der internen Leiterplatte verbunden und an das Bordnetz leitungstechnisch angeschlossen sein. Die Diagnoseeinrichtung dient insbesondere dazu, bestimmte Zustände des Relais zu detektieren und entsprechende Zustandsmeldungen auf einer integrierten oder mit dem Bordnetz verbindbaren Anzeigeeinrichtung auszugeben. Die detektierbaren und ausgebbaren Zustände sind insbesondere, ob das Relais EIN- oder AUS-geschaltet ist und/oder ob im Falle mehrerer parallelgeschalteter Leistungstransistoren im Relais, die Parallelschaltung korrekt erfolgt ist.

Nachfolgend wird die Erfindung anhand von Ausführungsbeispielen verdeutlicht.

Dabei zeigen
- Fig. 1: einen Hochstromkontakt gemäß der Erfindung in perspektivischer Darstellung
- Fig.2: ein Halbleiterleistungsrelais gemäß der Erfindung in schematischer Schnittdarstellung mit einem Hochstromkontakt gemäß Fig. 1.

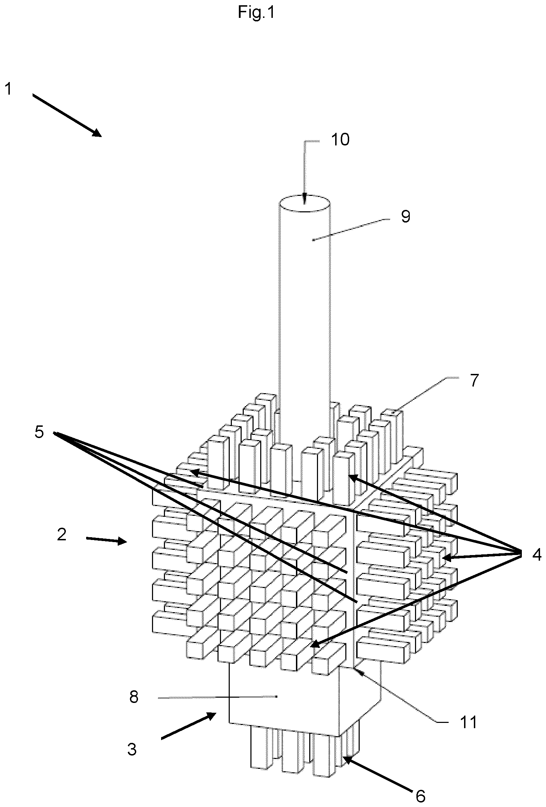

Figur 1 zeigt einen Hochstromkontakt 1 gemäß der Erfindung. Der Hochstromkontakt 1 weist einen ersten Abschnitt 2 und einen zweiten Abschnitt 3 auf. Die Abschnitte 2, 3 sind vorliegend mit Bezug auf die Längsachse des Hochstromkontakts koaxial zueinander angeordnet. Der erste Abschnitt 2 ist vorliegend mit kubischer Form ausgebildet. Er stellt erste Kontaktelemente 4 bereit, von denen jedes auf einer eigenen freien Kubusfläche 5 angeordnet ist. Dies sind die freien Kubusflächen.

Jedes Kontaktelement 4 ist von einer Vielzahl von Einpressstiften 7 gebildet, welche vorliegend in Reihen und Spalten regelmäßig über die jeweilige freie Kubusfläche 5 verteilt angeordnet sind. Die Kontaktelemente dienen der elektrischen und mechanischen Verbindung mit Leiterplatten, die die Leistungstransistorschaltungen bereitstellen. Durch die insgesamt fünf ersten Kontaktelemente können eine Vielzahl von Leistungstransistoren parallelgeschaltet und damit in Abhängigkeit der zu schaltenden hohen Ströme skaliert werden.

Der erste Abschnitt 2 ist mit dem zweiten Abschnitt 3 über eine kontaktelementfreie Kubusfläche unmittelbar verbunden.

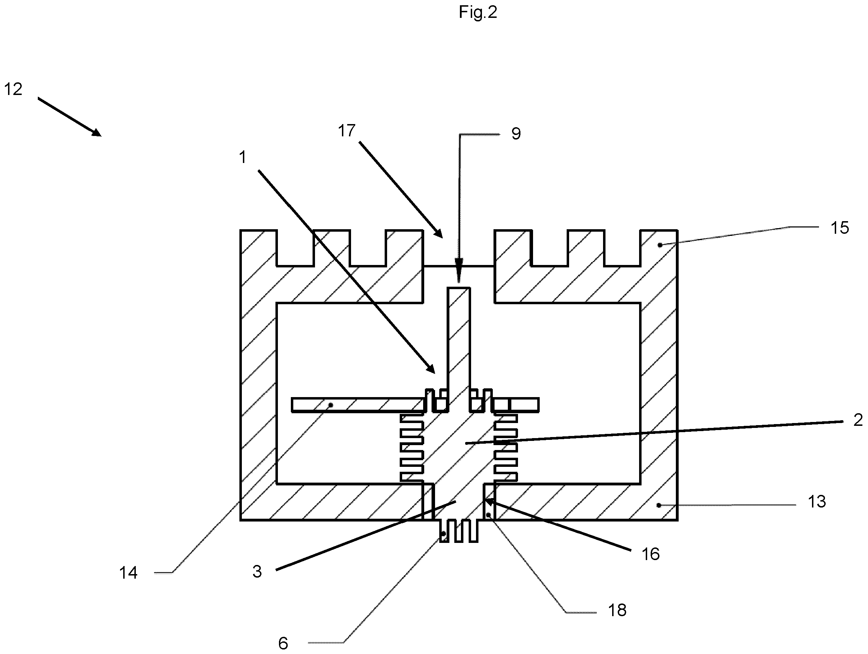

Der zweite Abschnitt 2 ist vorliegend ebenfalls als Kubus ausgebildet. Der erste Abschnitt 2 weist dabei eine größere Querschnittsfläche auf, als der zweite Abschnitt 3. Dabei bildet der erste Abschnitt an seiner kontaktelementfreien Kubusfläche ein Kopplungselement in Form einer Randfläche 11 aus. Die Randfläche dient der Übertragung einer Presskraft während des Einpressens vom Hochstromkontakt auf das in Figur 2 gezeigte Gehäuse des Halbleiterleistungsrelais.

Der zweite Abschnitt 3 weist auf seiner dem ersten Abschnitt gegenüberliegenden Seite ein zweites Kontaktelement 6 auf. das zweite Kontaktelement 6 ist durch eine Vielzahl von Einpressstiften 7 gebildet. Sie dienen der elektrischen und mechanischen Verbindung mit der Leiterplatte eines Bordnetzes eines Kraftfahrzeugs.

Am ersten Abschnitt 2 ist auf der dem zweiten Abschnitt gegenüberliegenden freien Kubusfläche 5 ein Kraftaufnahmeabschnitt 9 in Form eines zylindrischen Stabes angeordnet. Der zylindrische stabförmige Kraftaufnahmeabschnitt 9 weist ein freies Ende 10 mit einer Grundfläche auf, die dazu dient, von einem Presswerkzeug kontaktiert zu werden und die Presskraft aufzunehmen.

Der zweite Abschnitt 3 stellt überdies mit seinen Seitenflächen 8 einen Flansch zur Anordnung eines nicht dargestellten Strommessgeräts, insbesondere einer Induktionsspule, bereit.

Figur 2 zeigt ein Halbleiterleistungsrelais 12 mit einem als Strangpressprofil ausgebildetem Gehäuse 13.

Das Gehäuse 13 stellt einen Innenraum bereit, in welchem der Hochstromkontakt 1 und eine Leiterplatte 14 angeordnet sind. Die Leiterplatte 14 stellt eine Leistungstransistorschaltung bereit. Sie ist elektrisch und mechanisch mit dem Hochstromkontakt 1 über ein erstes Kontaktelement des ersten Abschnitts in Form einer Vielzahl von Einpressstiften 7 verbunden.

Das Gehäuse 13 weist Kühlrippen 15 auf zum Zwecke der Wärmeabführung auf.

Ferner weist das Gehäuse eine erste Öffnung 16 und eine zweite Öffnung 17 auf. Durch die erste Öffnung 16 ist der zweite Abschnitt 3 geführt. Und zwar derart, dass das zweite Kontaktelement 6 außerhalb des Gehäuses 13 angeordnet ist. Bestimmungsgemäß wird das zweite Kontaktelement in eine Leiterplatte des Bordnetzes eines Kraftfahrzeugs zum Zwecke der elektrischen und mechanischen Verbindung mit einem externen Stromkreis des Bordnetzes eingepresst.

Der übrige Teil des zweiten Abschnitts 3 ist vollständig innerhalb der ersten Öffnung 16 angeordnet. Die Innenwände der ersten Öffnung 16 sind durch ein Strommessgerät 18 gebildet, welches die als Flansch ausgebildeten Seitenwände des zweiten Abschnitts 3 kontaktiert. Das Strommessgerät 18 weist eine Hülle aus einem Dichtmaterial, wie etwa Gummi oder PVC auf. Das Strommessgerät 18 verschließt die Öffnung 16 dabei fluiddicht, insbesondere wasserdicht.

Gegenüber der ersten Öffnung 16 ist die zweite Öffnung 17 im Gehäuse 13 ausgebildet. Sie dient dazu, ein Presswerkzeug in den Innenraum des Gehäuses einzuführen und den Kraftaufnahmeabschnitt 9 während des Einpressvorgangs zu kontaktieren und mit einer linearen Presskraft zu beaufschlagen.

### Bezugszeichenliste

- 1: Hochstromkontakt
- 2: erste Abschnitt
- 3: zweiter Abschnitt
- 4: erste Kontaktelemente
- 5: freie Kubusflächen
- 6: zweites Kontaktelement
- 7: Einpressstifte
- 8: Seitenflächen
- 9: Kraftaufnahmeabschnitt
- 10: freies Ende
- 11: Randfläche
- 12: Halbleiterleistungsrelais
- 13: Gehäuse
- 14: Leiterplatte
- 15: Kühlrippe
- 16: erste Öffnung
- 17: zweite Öffnung
- 18: Strommessgerät

## Patentansprüche

1. Halbleiterleistungsrelais, insbesondere KFZ-Halbleiterleistungsrelais, mit wenigstens einem Gehäuse, einer im Inneren des Gehäuses angeordneten Leiterplatte aufweisend eine Leistungstransistorschaltung und einem teilweise im Gehäuse angeordneten Hochstromkontakt, welcher mit der Leiterplatte mittels eines ersten Kontaktelements leitungstechnisch verbunden ist, wobei der Hochstromkontakt über ein zweites Kontaktelement zur leitungstechnischen Verbindung der Leistungstransistorschaltung mit einer Leiterplatte eines externen Stromkreises, insbesondere dem Bordnetz eines Kraftfahrzeugs, verfügt, welches eine Vielzahl von Löt- und/oder Einpressstifte aufweist, wobei das zweite Kontaktelement durch eine erste Öffnung in der Wand des Gehäuses derart hindurch geführt ist, dass die Löt- und/oder Einpressstifte außerhalb des Gehäuses angeordnet sind.

2. Halbleiterleistungsrelais nach Anspruch 1, **dadurch gekennzeichnet, dass** Gehäusewand und Hochstromkontakt wenigstens in Richtung der Längserstreckung der Einpressstifte des zweiten Kontaktelements miteinander bewegungstechnisch derart gekoppelt sind, dass eine Bewegung des Hochstromkontakts eine Bewegung des Gehäuses und/oder eine Bewegung des Gehäuses eine Bewegung des Hochstromkontakts bewirkt.

3. Halbleiterleistungsrelais nach Anspruch 2, **dadurch gekennzeichnet, dass** der Hochstromkontakt und/oder das Gehäuse einen Kraftaufnahmeabschnitt aufweist, welcher dazu dient, mit einem Pressstempel eines Presswerkzeugs zusammenzuwirken.

4. Halbleiterleistungsrelais nach Anspruch 3, **dadurch gekennzeichnet, dass** das Gehäuse eine zweite Öffnung aufweist, durch welche der Kraftaufnahmeabschnitt des Hochstromkontakts hindurchgeführt ist und/oder das Presswerkzeug in das Gehäuse einführbar und der Kraftaufnahmeabschnitt des Hochstromkontakts und/oder des Gehäuses mit dem Presswerkzeug kontaktierbar ist.

5. Halbleiterleistungsrelais nach Anspruch 4, **dadurch gekennzeichnet, dass** der Kraftaufnahmeabschnitt des Hochstromkontakts stabförmig, mit insbesondere rundem, vorzugsweise kreisförmigem Querschnitt, ausgebildet ist.

6. Halbleiterleistungsrelais nach Anspruch 5, **dadurch gekennzeichnet, dass** der Hochstromkontakt wenigstens zwei miteinander verbundene Abschnitte aufweist, wobei der erste Abschnitt das erste Kontaktelement und den Kraftübertragungsabschnitt einerseits und der zweite Abschnitt das zweite Kontaktelement andererseits bereitstellt, wobei der erste Abschnitt und/oder der zweite Abschnitt ein Kopplungselement ausbilden, welches mit einem von der Wand des Gehäuses bereitgestellten korrespondierenden Element in Richtung der Längserstreckung der Einpressstifte des zweiten Kontaktelements formschlüssig zusammenwirkt.

7. Halbleiterleistungsrelais nach Anspruch 6, **dadurch gekennzeichnet, dass** das Kopplungselement von einer, insbesondere umlaufenden, Randfläche des ersten Abschnitts gebildet ist und dass das korrespondierende Element von einer, insbesondere umlaufenden, Randfläche der Innenwand des Gehäuses gebildet ist, die die erste Öffnung innenraumseitig einfasst.

8. Halbleiterleistungsrelais nach Anspruch 7, **dadurch gekennzeichnet, dass** der stabförmige Kraftaufnahmeabschnitt, der erste Abschnitt und der zweite Abschnitt des Hochstromelements hinsichtlich ihrer jeweiligen Längserstreckung auf einer gemeinsamen Längsachse angeordnet sind.

9. Halbleiterleistungsrelais nach Anspruch 8, **dadurch gekennzeichnet, dass** der erste Abschnitt eine größere Querschnittsfläche aufweist als der zweite Abschnitt, wobei der zweite Abschnitt innerhalb der ersten Öffnung und der erste Abschnitt im Innenraum des Gehäuses angeordnet ist.

10. Halbleiterleistungsrelais nach einem der Ansprüche 1 bis 9, **dadurch gekennzeichnet, dass** das erste Kontaktelement zur leitungstechnischen Verbindung mit der Leiterplatte eine Vielzahl von Löt- und/oder Einpressstiften aufweist.

11. Halbleiterleistungsrelais nach Anspruch 10, **dadurch gekennzeichnet, dass** der erste Abschnitt wenigstens ein weiteres Kontaktelement in Form einer Vielzahl von Löt- und/oder Einpressstiften zur leitungstechnischen Verbindung mit einer weiteren eine Leistungstransistorschaltung bereitstellenden Leiterplatte aufweist, wobei sich die Löt- und/oder Einpressstifte des weiteren Kontaktelements in Längsrichtung in einem Winkel relativ zu den Löt- und/oder Einpressstiften des ersten Kontaktelements erstrecken.

12. Halbleiterleistungsrelais nach einem der Ansprüche 10 oder 11, **dadurch gekennzeichnet, dass** der erste Abschnitt quaderförmig, insbesondere kubisch, ausgebildet ist, wobei eine der Quaderflächen mit dem zweiten Abschnitt verbunden ist und die übrigen Quaderflächen freie Quaderflächen, wobei auf einer freien Quaderfläche ein Kontaktelement angeordnet ist, wobei die Einpressstifte des jeweiligen Kontaktelements jeweils lotrecht auf der jeweiligen freien Quaderfläche stehen.

13. Halbleiterleistungsrelais nach Anspruch 12, **dadurch gekennzeichnet, dass** der Kraftaufnahmeabschnitt des Hochstromkontakts von der freien Quaderfläche gebildet oder darauf angeordnet ist, die derjenigen Quaderflächen gegenüberliegend angeordnet ist, die mit dem zweiten Abschnitt des Hochstromkontakts verbunden ist.

14. Verfahren zur Verbindung eines Halbleiterleistungsrelais mit einer Leiterplatte eines KFZ-Bordnetzes, **dadurch gekennzeichnet, dass** ein Halbleiterleistungsrelais nach einem der Ansprüche 1 bis 13 als fertige Baugruppe mit der Leiterplatte mechanisch und leitungstechnisch verbunden wird, wobei mittels eines Presswerkzeugs eine in Richtung der Leiterplatte entlang der Längsachse der Einpressstifte des zweiten Kontaktelements gerichtete Kraft auf den Kraftaufnahmeabschnitt des Hochstromkontakts und/oder des Gehäuses eingebracht wird, wobei die Einpressstifte des zweiten Kontaktelements in korrespondierende Stiftaufnahmen der Leiterplatte des KFZ-Bordnetzes eingepresst werden.

15. Verfahren nach Anspruch 14, **dadurch gekennzeichnet, dass** mit einem Pressstempel des Presswerkzeugs auf den stabförmigen Kraftaufnahmeabschnitt des Hochstromkontakts gepresst wird, wobei die dabei auf den Hochstromkontakt wirkende Presskraft von einem Kopplungselement des ersten Abschnitts auf ein von der Wand des Gehäuses bereitgestelltes korrespondierendes Element übertragen wird, wobei während des Pressvorgangs ein Formschluss zwischen dem Kopplungselement und dem korrespondierenden Element hergestellt wird.
